(19) **Europäisches Patentamt**
**European Patent Office**
**Office européen des brevets**

(11) **EP 2 798 667 B1**

(12) **FASCICULE DE BREVET EUROPEEN**

(45) Date de publication et mention
de la délivrance du brevet:
**09.03.2016 Bulletin 2016/10**

(51) Int Cl.:
*H01L 23/00* $^{(2006.01)}$    *H01L 21/762* $^{(2006.01)}$
*H01L 21/20* $^{(2006.01)}$

(21) Numéro de dépôt: **12819115.2**

(22) Date de dépôt: **27.12.2012**

(86) Numéro de dépôt international:
**PCT/FR2012/053089**

(87) Numéro de publication internationale:
**WO 2013/098528 (04.07.2013 Gazette 2013/27)**

(54) **PROCEDE DE FABRICATION D'UNE STRUCTURE MULTICOUCHE SUR UN SUPPORT**

**VERFAHREN ZUR HERSTELLUNG EINER MEHRSCHICHTIGEN STRUKTUR AUF EINEM SUBSTRAT**

**METHOD FOR MANUFACTURING A MULTILAYER STRUCTURE ON A SUBSTRATE**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **29.12.2011 FR 1162525**

(43) Date de publication de la demande:
**05.11.2014 Bulletin 2014/45**

(73) Titulaire: **Commissariat à l'Énergie Atomique et aux Énergies Alternatives 75015 Paris (FR)**

(72) Inventeurs:
• **ROSSINI, Umberto**
  **F-38500 Coublevie (FR)**
• **FLAHAUT, Thierry**
  **F-38220 Cholonge (FR)**

• **LARREY, Vincent**
  **F-38140 LaMurette (FR)**

(74) Mandataire: **Thibon, Laurent Cabinet Beaumont 1, rue Champollion 38000 Grenoble (FR)**

(56) Documents cités:
**WO-A1-2011/010685    WO-A2-2008/082723**

• **ZENG K ET AL: "Investigation of mechanical properties of transparent conducting oxide thin films", THIN SOLID FILMS, ELSEVIER-SEQUOIA S.A. LAUSANNE, CH, vol. 443, no. 1-2, 22 octobre 2003 (2003-10-22), pages 60-65, XP004458341, ISSN: 0040-6090, DOI: 10.1016/S0040-6090(03)00915-5**

**Description**

Domaine de l'invention

La présente invention concerne un procédé de fabrication d'une structure multicouche, correspondant par exemple à une plaquette de circuits intégrés, sur un support final par collage moléculaire. La présente invention concerne également un support initial pour une telle structure multicouche. Le document WO 2008/082723 (publié le 10 Juillet 2008) décrit dans le cadre de l'état de la technique un tel procédé, ainsi que la structure correspondante.

Exposé de l'art antérieur

Pour certaines applications, il est souhaitable de réaliser une plaquette de circuits intégrés sur un support. En particulier, pour des applications dans le domaine de l'optique, le support doit être isolant et transparent. Il s'agit par exemple de verre. Un exemple d'application concerne la fabrication d'un écran de visualisation transmissif.

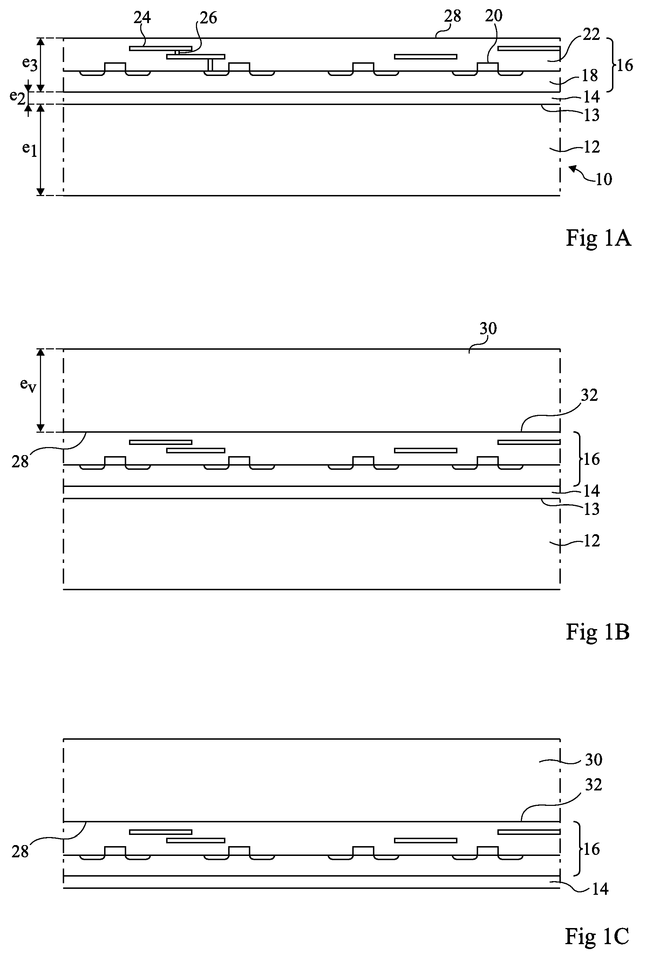

Les figures 1A à 1C représentent des coupes schématiques de structures obtenues à des étapes successives d'un procédé de fabrication d'une plaquette de circuits intégrés sur un support par collage moléculaire.

La figure 1A représente, de façon schématique, un élément 10 ayant une structure du type SOI (acronyme anglais pour Silicon On Insulator).

L'élément 10 comprend un support initial 12, par exemple un substrat de silicium monocristallin. L'épaisseur $e_1$ du support initial 12 est, par exemple, de plusieurs centaines de micromètres, et est, par exemple, égale à environ 700 $\mu$m. Le support initial 12 peut correspondre à un cylindre dont le diamètre est supérieur à une centaine de millimètres, et est égal, par exemple, à environ 200 mm ou 300 mm. Le support initial 12 comprend une face plane 13 recouverte d'une couche isolante 14, par exemple en dioxyde de silicium. L'épaisseur $e_2$ de la couche isolante 14 est, par exemple, de l'ordre de 1 $\mu$m. La couche isolante 14 est recouverte d'une plaquette de circuits intégrés 16. La plaquette de circuits intégrés 16 comprend un empilement de couches dans lequel sont formés des composants électroniques actifs et/ou passifs et des pistes conductrices reliant ces composants. A titre d'exemple, la plaquette de circuits intégrés 16 comprend une couche 18 d'un matériau semiconducteur, par exemple du silicium monocristallin, recouvrant la couche isolante 14 et dans et sur laquelle sont formés les composants électroniques actifs et/ou passifs, par exemple des transistors 20. La plaquette de circuits intégrés 16 comprend, en outre, un empilement de couches isolantes 22, par exemple en dioxyde de silicium, recouvrant la couche de silicium 18 et dans lequel sont formés des pistes 24 et des vias 26 d'un matériau conducteur pouvant venir au contact des composants électroniques. A titre d'exemple, l'épaisseur $e_3$ de la plaquette 16 est de l'ordre de quelques micromètres. La dernière couche isolante de l'empilement 22 de couches isolantes forme une face supérieure plane 28 opposée au support 12.

La figure 1B représente la structure obtenue après la réalisation d'un collage moléculaire entre la face 28 de l'élément 10 et un support final 30. Le support final 30 est en un matériau différent du silicium, par exemple en verre. L'épaisseur $e_v$ du support final 30 est supérieure à plusieurs centaines de micromètres, et est, par exemple, égale à environ 700 $\mu$m. Le support final 30 comprend une face 32 appliquée contre la face 28. Le collage moléculaire consiste à créer une liaison entre les faces 28 et 32 sans l'apport de matière extérieure (comme une colle ou une matière adhésive). Pour cela, les faces 28 et 32, convenablement nettoyées, sont mises au contact l'une de l'autre à température ambiante. Une pression peut être exercée localement sur le support 30 pour amorcer le collage. Le front de propagation de la zone collée se répand alors de la région d'amorce sur l'ensemble des surfaces en regard.

La figure 1C représente la structure obtenue après le retrait du support initial 12. Le retrait du support initial 12 peut comprendre une étape de rectification mécano-chimique pour retirer la plus grande partie du support initial 12 suivie d'une étape de gravure chimique sélective pour retirer le reste du support initial 12. La couche isolante 14 peut servir de couche d'arrêt lors du retrait du support initial 12.

Le procédé se poursuit généralement par la réalisation de vias conducteurs au travers de la couche isolante 14 et de la couche de silicium 18 et connectés à des pistes métalliques 24 de la plaquette de circuits intégrés 16. La formation de ces vias comprend des étapes de photolithographie, incluant des étapes dans lesquelles une couche d'une résine photosensible recouvrant la couche isolante 14 est exposée à un rayonnement au travers d'un masque pour reproduire le motif du masque sur la couche de résine. Dans ce but, le dispositif d'exposition, qui comprend notamment les systèmes optiques pour former le motif dans la couche de résine photosensible, doit être placé avec précision par rapport à la plaquette de circuits intégrés 16.

Dans un procédé de fabrication à une échelle industrielle, les étapes de photolithographie doivent être réalisées le plus rapidement possible. Dans ce but, le dispositif d'exposition est réglé au préalable pour que le motif à transférer se forme sans réglage supplémentaire de façon correcte dans la couche de résine pour une plaquette de circuits intégrés qui aurait les dimensions attendues.

Toutefois, des déformations sont observées dans la plaquette de circuits intégrés 16 après l'étape de collage. En particulier, un rétrécissement est observé, c'est-à-dire que deux repères formés sur la face de collage 28 avant l'étape de collage sont rapprochés l'un de l'autre après l'étape de collage. Le rétrécissement relatif peut être de l'ordre de 20 ppm.

Ces déformations peuvent être généralement au moins en partie compensées par le dispositif d'exposition. Toutefois, ceci entraîne des étapes de réglage supplémentaires qui ne sont pas compatibles avec la réalisation d'un procédé de fabrication à une échelle industrielle. En outre, dans certains cas, ces déformations peuvent être trop importantes pour être compensées par le dispositif d'exposition.

Un besoin existe donc d'un procédé de fabrication d'une structure multicouche, correspondant par exemple à une plaquette de circuits intégrés, sur un support final par collage moléculaire de la plaquette sur le support dans lequel les déformations dans la plaquette de circuits intégrés qui résultent de l'opération de collage sont réduites, voire supprimées.

Résumé

Un objet de la présente invention est de proposer un procédé de fabrication d'une structure multicouche sur un support par collage moléculaire qui pallie les inconvénients des procédés connus.

Selon un autre objet de la présente invention, les déformations relatives dans la structure multicouche qui résultent de l'opération de collage sont inférieures à 5 ppm.

Selon un autre objet de la présente invention, le procédé de fabrication par collage moléculaire comporte un nombre réduit d'étapes supplémentaires par rapport à un procédé de fabrication par collage moléculaire connu.

Ainsi, la présente invention prévoit un procédé de fabrication d'une structure multicouche sur un premier support. Le procédé comprend l'utilisation du premier support en un premier matériau ayant un module d'Young $E_V$ et une épaisseur $e_V$, et l'utilisation d'un second support recouvert de la structure multicouche, le second support étant en un second matériau ayant un module d'Young $E_S$, différent du module d'Young $E_V$, et une épaisseur $e_S$, les épaisseurs $e_S$ et $e_V$ vérifiant, à 10 % près, la relation :

$$e_S \; = \; \frac{E_V}{E_S} \, e_V \;\; ;$$

le collage moléculaire entre le premier support et la structure multicouche ; et le retrait du second support.

Selon un exemple de réalisation de l'invention, le second support a initialement une épaisseur strictement supérieure à l'épaisseur $e_S$, le procédé comprenant, en outre, avant l'étape de collage, l'amincissement du second support jusqu'à l'épaisseur $e_S$.

Selon un exemple de réalisation de l'invention, les épaisseurs $e_S$ et $e_V$ sont supérieures à 50 $\mu$m.

Selon un exemple de réalisation de l'invention, le second matériau est du silicium monocristallin.

Selon un exemple de réalisation de l'invention, le premier matériau est isolant.

Selon un exemple de réalisation de l'invention, le premier matériau est transparent.

Selon un exemple de réalisation de l'invention, le premier matériau est du verre.

La présente invention prévoit également un support pour une structure multicouche destinée à être collée à un support supplémentaire en un premier matériau ayant un module d'Young $E_V$ et une épaisseur $e_V$, le support étant en un second matériau ayant un module d'Young $E_S$, différent du module d'Young $E_V$, et une épaisseur $e_S$ vérifiant, à 10 % près, la relation :

$$e_S \; = \; \frac{E_V}{E_S} \, e_V \;\; .$$

Selon un exemple de réalisation de l'invention, le second matériau est du silicium monocristallin.

Brève description des dessins

Ces objets, caractéristiques et avantages, ainsi que d'autres seront exposés en détail dans la description suivante d'exemples de réalisation particuliers faite à titre non limitatif en relation avec les figures jointes parmi lesquelles :

les figures 1A à 1C, décrites précédemment, représentent les structures obtenues à des étapes successives d'un procédé de fabrication connu d'une plaquette de circuits intégrés sur un support isolant ; et
les figures 2A à 2D représentent les structures obtenues à des étapes successives d'un exemple de réalisation d'un procédé de fabrication d'une plaquette de circuits intégrés sur un support isolant selon la présente invention.

Description détaillée

Par souci de clarté, de mêmes éléments ont été désignés par de mêmes références aux différentes figures et, de plus, comme cela est habituel dans la représentation des circuits intégrés, les diverses figures ne sont pas tracées à l'échelle.

Le principe de l'invention se base sur une analyse des phénomènes physiques qui se produisent lors d'une opération de collage moléculaire de deux supports comprenant des matériaux de natures différentes. Au niveau du front de propagation de la zone collée, on observe une mise en extension locale des supports. Lorsque les modules d'Young des matériaux des supports sont différents, les déformations locales résultantes ne sont pas identiques. La face collée du support dont le module d'Young est le plus faible s'étend davantage que la face collée du support dont le module d'Young est le plus élevé. Le collage se produit alors que les supports sont déformés. Après avoir collé les deux supports et retiré l'un des supports pour ne laisser qu'une couche mince collée à l'autre support, des déformations dans la couche mince sont observées.

En général, lors du collage d'une plaquette de circuits intégrés sur un support final en verre, la plaquette de circuits intégrés repose sur un support initial, retiré par la suite, qui est un substrat de silicium monocristallin. Les inventeurs ont mis en évidence que, lors du collage moléculaire de la plaquette de circuits intégrés sur le support final, les déformations résultantes observées dans la plaquette de circuits intégrés sont essentiellement dues à la nature du matériau du support initial utilisé pour l'application de la plaquette de circuits intégrés contre le support final. En effet, l'épaisseur de la plaquette de circuits intégrés est faible par rapport à l'épaisseur du support initial et il est possible de la négliger. Le module d'Young du verre est inférieur au module d'Young du silicium de sorte que l'on observe, après le collage, un agrandissement négatif dans un plan de la plaquette de circuits intégrés parallèle aux faces collées.

Lors de la phase de collage entre le support final et le support initial, les énergies élastiques stockées dans chaque support sont égales, ce qui se traduit par la relation (1) suivante :

$$\frac{1}{2} \, V_V E_V \varepsilon_V \;=\; \frac{1}{2} \, V_S E_S \varepsilon_S \qquad\qquad (1)$$

où $V_V$ est le volume du support final, $V_S$ est le volume du support initial, $E_V$ est le module d'Young du support final, $E_S$ est le module d'Young du support initial, $\varepsilon_V$ est la déformation du support final et $\varepsilon_S$ est la déformation du support initial. Les modules d'Young $E_V$ et $E_S$ sont les modules d'Young mesurés dans un plan parallèle aux faces collées. Le module d'Young de l'un des supports peut ne pas être constant dans un plan parallèle aux faces collées. Dans ce cas, le module d'Young $E_S$ ou $E_V$ de la relation (1) correspond à une valeur moyenne.

Les inventeurs ont mis en évidence que lorsque les déformations $\varepsilon_V$ et $\varepsilon_S$ sont égales, cela signifie que, après collage, le support initial et le support final retrouvent un état d'équilibre sans déformation. Il est possible d'imposer que la déformation $\varepsilon_V$ dans le support final soit égale à la déformation $\varepsilon_S$ dans le support initial si les volumes $V_V$ et $V_S$ vérifient la relation (2) suivante :

$$V_V E_V \;=\; V_S E_S \qquad\qquad (2)$$

Les supports initial et final ayant la même surface en regard, la relation (2) devient la relation (3) suivante :

$$e_S \;=\; \frac{E_V}{E_S} \, e_V \qquad\qquad (3)$$

où $e_S$ est l'épaisseur du support initial et $e_V$ est l'épaisseur du support final. De façon générale, pour la formation d'une plaquette de circuits intégrés sur un support en verre, le module d'Young du support en verre est d'environ 70 GPa tandis que le module d'Young du support initial en silicium monocristallin est d'environ 140 GPa. L'épaisseur $e_S$ du support initial est alors obtenue par la relation (4) suivante :

$$e_S \approx 0{,}5 e_V \qquad\qquad (4)$$

Selon un mode de réalisation, il est prévu une étape de détermination de l'épaisseur $e_S$ du support initial et l'épaisseur $e_V$ du support final de façon que les épaisseurs $e_S$ et $e_V$ vérifient à 10 % près la relation (3) indiquée précédemment. Cette étape peut être mise en oeuvre par un ordinateur.

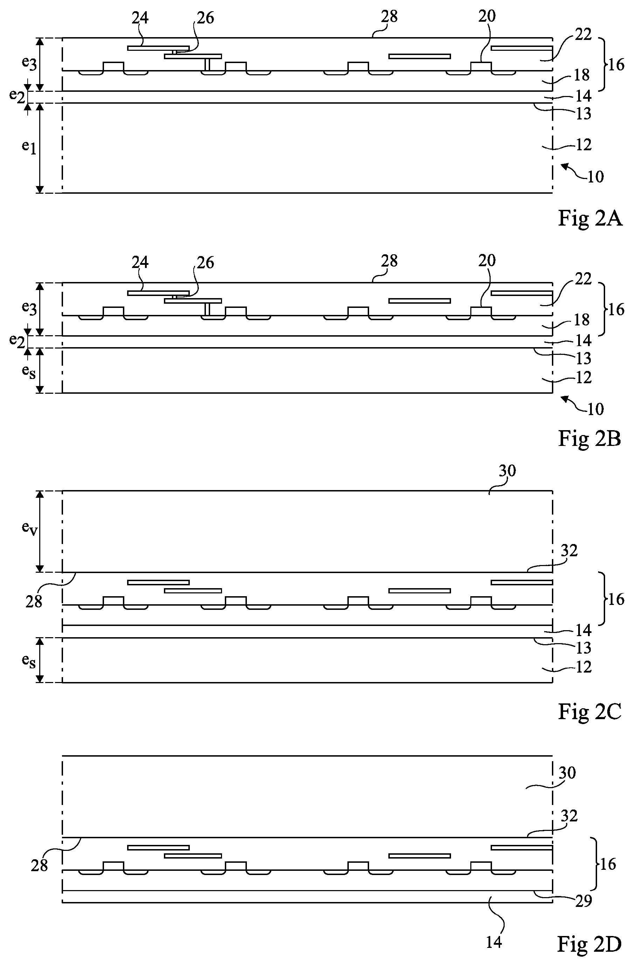

Les figures 2A à 2D représentent les structures obtenues à des étapes successives d'un exemple de réalisation d'un procédé de fabrication d'une plaquette de circuits intégrés sur un support isolant selon l'invention.

La figure 2A représente une structure 10 identique à la structure représentée en figure 1A. L'épaisseur $e_1$ du support initial 12 est par exemple de l'ordre de 700 micromètres. Ceci correspond à l'épaisseur standard des substrats de silicium utilisés de façon classique dans les procédés de fabrication de circuits intégrés.

La figure 2B représente la structure obtenue après une étape d'amincissement du support initial 12. Cette étape peut être réalisée par rectification mécano-chimique. L'épaisseur du support intermédiaire 12 est réduite jusqu'à l'épaisseur $e_S$, donnée par la relation (4). L'égalité de la relation (4) peut être vérifiée jusqu'à 10 % tout en donnant des résultats satisfaisants. A titre d'exemple, lorsque l'épaisseur $e_V$ du support 30 final en verre est de l'ordre de 700 $\mu$m, l'épaisseur réduite $e_S$ peut être de l'ordre de 350 $\mu$m.

La figure 2C représente la structure obtenue après la réalisation d'un collage moléculaire entre les faces 28 et 32. Le support final 30 est en un matériau isolant et transparent. Il s'agit par exemple de verre. Il s'agit par exemple du verre à base de borosilicate commercialisé par la société Corning sous l'appellation Eagle 2000.

De façon connue, le procédé de collage moléculaire peut comprendre des étapes de préparation des faces 28 et 32 à coller. Si besoin, un traitement peut être réalisé pour que la rugosité des faces 28 et 32 soit adaptée à la réalisation d'un collage moléculaire. Les étapes de préparation peuvent, en outre, comprendre le nettoyage des faces 28 et 32 visant à retirer la majorité des particules présentes sur les faces 28 et 32 dont le diamètre est, par exemple, supérieur à 0,2 $\mu$m. Les étapes de préparation peuvent, en outre, comprendre un traitement chimique des faces 28 et 32 pour favoriser un collage moléculaire de type hydrophile ou hydrophobe.

Le collage peut être réalisé à température ambiante. Le collage peut être amorcé en plaquant les faces 28 et 32 l'une contre l'autre et en appliquant une pression localisée sur l'un des supports. Le collage débute alors dans une zone d'amorce et un front de propagation de collage se répand depuis la zone d'amorce jusqu'à ce que la face 28 soit collée en totalité à la face 32. Lorsque les supports 30 et 12 sont cylindriques, la zone d'amorce peut être prévue en région centrale des faces 28 et 32. A titre de variante, la zone d'amorce peut être située sur un bord des faces 28 et 32. Une étape de recuit peut ensuite être réalisée à une température inférieure à la température maximale autorisée pour les matériaux utilisés. Lorsque le support final 30 est en verre, le recuit peut être réalisé jusqu'à une température de 400°C à 500°C pendant une durée d'au moins 1 heure, et en général de plusieurs heures, pour augmenter l'énergie de collage.

La figure 2D représente la structure obtenue après le retrait du support initial 12. Le retrait du support initial 12 peut comprendre une étape de rectification mécano-chimique pour retirer la plus grande partie du support initial 12 suivie d'une étape de gravure chimique sélective pour retirer le reste du support initial 12. La couche isolante 14 peut servir de couche d'arrêt lors du retrait du support initial 12. Les déformations relatives dans la plaquette de circuits intégrés 16 qui résultent de l'opération de collage sont inférieures à 5 ppm.

Le procédé se poursuit généralement par la formation de vias conducteurs au travers de la couche isolante 14 et de la couche de silicium 12.

Des exemples de réalisation particuliers de la présente invention ont été décrits. Diverses variantes et modifications apparaîtront à l'homme de l'art. En particulier, bien que dans l'exemple de réalisation décrit précédemment, le support final soit en verre et le support initial soit en silicium, il est clair que la présente invention peut s'appliquer au collage moléculaire de tout type de matériau ayant des modules d'Young différents. A titre d'exemple, le support initial et/ou le support final peuvent être en un matériau semiconducteur, par exemple du silicium, du germanium ou de l'arséniure de gallium, en un matériau isolant, par exemple du quartz ou du saphir, ou en tout matériau à bas coût pouvant être utilisé pour réaliser un substrat poignée, par exemple un polymère. De plus, bien que dans l'exemple de réalisation décrit précédemment, l'épaisseur du support initial soit réduite jusqu'à l'épaisseur $e_S$, il est clair que l'étape de rectification d'épaisseur peut être réalisée sur le support final seulement ou à la fois sur le support initial et le support final.

**Revendications**

1. Procédé de fabrication d'une structure multicouche (16) sur un premier support (30), le procédé comprenant les étapes successives suivantes :

   prévoir le premier support en un premier matériau ayant un module d'Young $E_V$ et une épaisseur $e_V$, et un second support (12) recouvert de la structure multicouche, le second support étant en un second matériau ayant un module d'Young $E_S$, différent du module d'Young $E_V$, et une épaisseur $e_S$, les épaisseurs $e_S$ et $e_V$ vérifiant, à 10 % près, la relation :

$$e_s = \frac{E_v}{E_s} e_v \quad ;$$

réaliser un collage moléculaire entre le premier support et la structure multicouche ; et
retirer le second support.

2. Procédé de fabrication selon la revendication 1, dans lequel le second support (12) a initialement une épaisseur strictement supérieure à l'épaisseur $e_S$, le procédé comprenant, en outre, avant l'étape de collage, l'amincissement du second support jusqu'à l'épaisseur $e_S$.

3. Procédé de fabrication selon la revendication 1 ou 2, dans lequel les épaisseurs $e_S$ et $e_V$ sont supérieures à 50 $\mu$m.

4. Procédé de fabrication selon l'une quelconque des revendications 1 à 3, dans lequel le second matériau est du silicium monocristallin.

5. Procédé de fabrication selon l'une quelconque des revendications 1 à 4, dans lequel le premier matériau est isolant.

6. Procédé de fabrication selon l'une quelconque des revendications 1 à 5, dans lequel le premier matériau est transparent.

7. Procédé de fabrication selon l'une quelconque des revendications 1 à 6, dans lequel le premier matériau est du verre.

8. Support (12) pour une structure multicouche (16) destinée à être collée à un support (30) supplémentaire en un premier matériau ayant un module d'Young $E_V$ et une épaisseur $e_V$, le support étant en un second matériau ayant un module d'Young $E_S$, différent du module d'Young $E_V$, et une épaisseur $e_S$ vérifiant, à 10 % près, la relation :

$$e_s = \frac{E_v}{E_s} e_v \quad \cdot$$

9. Support selon la revendication 8, dans lequel le second matériau est du silicium monocristallin.

**Patentansprüche**

1. Ein Verfahren zur Herstellung einer mehrschichtigen Struktur (16) auf einem ersten Träger (30) wobei das Verfahren die folgenden sukzessiven Schritte aufweist:

Vorsehen des ersten Trägers, hergestellt aus einem ersten Material mit einem Youngschen Modul Ev und einer Dicke $e_V$ und eines zweiten Trägers (12) beschichtet mit der mehrschichtigen Struktur, wobei der zweite Träger aus einem zweiten Material hergestellt ist, mit einem Youngschen Modul Es unterschiedlich vom Youngschen Modul Ev und mit einer Dicke $e_S$, wobei die Dicken $e_s$ und $e_v$ innerhalb von 10% der Bedingung:

$$e_s = \frac{E_v}{E_s} e_v$$

genügen;
Ausführen einer Molekularverbindung zwischen dem ersten Träger und der Mehrschichtstruktur; und
Entfernen des zweiten Trägers.

2. Das Herstellungsverfahren nach Anspruch 1, wobei der zweite Träger (12) anfangs eine größere Dicke als die Dicke $e_s$ besitzt, und wobei das Verfahren ferner vor dem Verbindungsschritt das Verdünnen des zweiten Trägers hinab zur Dicke $e_s$ aufweist.

3. Das Herstellungsverfahren nach Anspruch 1 oder 2, wobei die Dicken $e_s$ und $e_v$ größer als 50$\mu$m sind.

**4.** Das Herstellungsverfahren nach einem der Ansprüche 1 bis 3, wobei das zweite Material ein Einkristall-Silizium ist.

**5.** Das Herstellungsverfahren nach einem der Ansprüche 1 bis 4, wobei das erste Material isolierend ist.

**6.** Das Herstellungsverfahren nach einem der Ansprüche 1 bis 5, wobei das erste Material transparent ist.

**7.** Das Herstellungsverfahren nach einem der Ansprüche 1 bis 6, wobei das erste Material Glas ist.

**8.** Ein Träger (12) für eine Mehrschichtstruktur (16), vorgesehen zur Verbindung mit einem zusätzlichen Träger (30) hergestellt aus einem ersten Material mit einem Youngschen Modul Ev und einer Dicke $e_v$, wobei der Träger aus einem zweiten Material hergestellt ist, mit einem Youngschen Modul Es unterschiedlich vom Youngschen Modul Ev und mit einer Dicke $e_s$ die nachweisbar innerhalb von 10% der folgenden Beziehung liegt.

$$e_s \;=\; \frac{E_v}{E_s}\, e_v$$

**9.** Der Träger nach Anspruch 8, wobei das zweite Material ein Einkristall-Silizium ist.

**Claims**

**1.** A method of manufacturing a multilayer structure (16) on a first support (30), the method comprising the successive steps of:

> providing the first support made of a first material having a Young's modulus $E_V$ and a thickness $e_V$, and a second support (12) covered with the multilayer structure, the second support being made of a second material having a Young's modulus $E_S$ different from Young's modulus $E_V$, and a thickness $e_S$, thicknesses $e_S$ and $e_V$ verifying, to within 10%, relation:

$$e_s \;=\; \frac{E_v}{E_s}\, e_v \;;$$

> performing a molecular bonding between the first support and the multilayer structure; and
> removing the second support.

**2.** The manufacturing method of claim 1, wherein the second support (12) initially has a thickness greater than thickness $e_S$, the method further comprising, before the bonding step, thinning the second support down to thickness $e_S$.

**3.** The manufacturing method of claim 1 or 2, wherein thicknesses $e_S$ and $e_V$ are greater than 50 $\mu$m.

**4.** The manufacturing method of any of claims 1 to 3, wherein the second material is single-crystal silicon.

**5.** The manufacturing method of any of claims 1 to 4, wherein the first material is isolating.

**6.** The manufacturing method of any of claims 1 to 5, wherein the first material is transparent.

**7.** The manufacturing method of any of claims 1 to 6, wherein the first material is glass.

**8.** A support (12) for a multilayer structure (16) intended to be bonded to an additional support (30) made of a first material having a Young's modulus $E_V$ and a thickness $e_V$, the support being made of a second material having a Young's modulus $E_S$, different from Young's modulus $E_V$, and a thickness $e_S$ verifying, to within 10%, relation:

$$e_s \;=\; \frac{E_V}{E_S}\, e_v \;.$$

9. The support of claim 8, wherein the second material is single-crystal silicon.

Fig 1A

Fig 1B

Fig 1C

Fig 2A

Fig 2B

Fig 2C

Fig 2D

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2008082723 A